# EUROPEAN PATENT APPLICATION

(11) **EP 4 704 152 A1**
(43) Date of publication of application: **04.03.2026**
(21) Application number: 25183233.3
(22) Date of filing: 17.06.2025
(51) Int. Cl.: H01L 23/473, H01L 23/48, H01L 23/522, H01L 23/528, H01L 23/498, H01L 25/065

(54) **SYSTEMS AND METHODS FOR INTEGRATED SEMICONDUCTOR PACKAGING**

(30) Priority: 26.08.2024 US 202463687277 P; 29.12.2024 US 202419004448
(71) Applicant: Samsung Electronics Co., Ltd., Suwon-si, Gyeonggi-do 16677 (KR)
(72) Inventor: LI, Yan, San Jose, CA, 95134, (US); KIM, WooPoung, San Jose, CA, 95134 (US)
(74) Representative: Kuhnen & Wacker Patent- und Rechtsanwaltsbüro PartG mbB

(57) **Abstract**

A system and a method for a semiconductor integrated package are disclosed. An interposer (210) has a top surface and a bottom surface. A first circuit layer (230) is disposed on the top surface by a first bonding and has at least one first circuit (232, 234). A second circuit layer (240) is disposed on the first circuit layer (230) by a second bonding and has at least one second circuit (242, 244). A thermal layer (260) having an embedded liquid cooling channel (265) is bonded on the second circuit layer (240).

## Description

### TECHNICAL FIELD

The disclosure generally relates to semiconductor packaging. More particularly, the subject matter disclosed herein relates to integrated packaging.

### BACKGROUND

Demands in high performance computing in mobile communication, artificial intelligence (AI), machine learning (ML), and media computing have created many requirements in semiconductor technology. These requirements include large storage capacity, low power consumption, small footprints, and fast accesses to caches, static random-access memory (SRAM), dynamic random-access memory (DRAM), and high-bandwidth memory (HBM) devices.

Designing systems that utilize these components faces several challenges. Placement of heterogeneous components on a small platform requires a complex and delicate balance between power consumption, signal integrity, and propagation delays. Suppressing heat dissipation among components often creates unsatisfactory thermal management or bottlenecks in interconnections.

### SUMMARY

To overcome these issues devices and methods for integrated packaging according to the appended claims are provided. Further, systems and methods are described herein for a technique of fabricating highly integrated semiconductor packages that combines heterogenous components such as applications specific integrated circuits (ASICs), memories, and input/output (IO) circuits. The technique employs a systematic integrating approach to achieve many objectives for structural coherence including gapless three-dimensional (3D) integration of heterogeneous components, flexibility in component placement, reduced interconnection distances using gapless die stacking, improved thermal management with diamond or silicon (Si)/glass wafers having embedded cooling channels, and improved power delivery performance with glass or Si substrate having embedded decoupling capacitors.

In an embodiment, a device (e.g. a semiconductor integrated package) includes at least an interposer, a first circuit layer, a second circuit layer, and a thermal layer. The interposer has a top surface and a bottom surface. The first circuit layer is bonded to or disposed on the top surface by a first bonding (bonding interface), e.g. a die-to-wafer hybrid bonding (D2WHB), and has at least one first circuit. The second circuit layer is bonded to or disposed on the first circuit layer by a second bonding (bonding interface), e.g. a D2WHB, and has at least one second circuit. The thermal layer having an embedded liquid cooling channel is bonded on the second circuit layer.

In an embodiment, a method for integrated packaging includes: disposing an interposer having a top surface and a bottom surface on a wafer; bonding a first circuit layer having at least one first circuit on the top surface using a first bonding; and bonding a second circuit layer having at least one second circuit on the first circuit layer using a second bonding; and bonding a thermal layer having an embedded liquid cooling channel on the second circuit layer.

### BRIEF DESCRIPTION OF THE DRAWINGS

In the following section, the aspects of the subject matter disclosed herein will be described with reference to exemplary embodiments illustrated in the figures, in which:
FIG. 1 is a block diagram illustrating a system according to an embodiment.
FIG. 2 is a diagram illustrating an integrated package with BSPDN according to an embodiment.
FIG. 3 is a diagram illustrating an integrated package having a substrate according to an embodiment.
FIG. 4 is a diagram illustrating an integrated package with a dual configuration according to an embodiment.
FIG. 5 is a diagram illustrating an integrated package with an alternative BSPDN arrangement according to an embodiment.
FIG. 6 is a diagram illustrating an integrated package with an alternative first circuit arrangement according to an embodiment.
FIG. 7 is a diagram illustrating an integrated package with a customized memory stack according to an embodiment.
FIG. 8 is a diagram illustrating an integrated package with a mix of alternative arrangements according to an embodiment.
FIG. 9 is a diagram illustrating an overview of a manufacturing process flow according to an embodiment.
FIG. 10 is a diagram illustrating a first circuit bonding process according to an embodiment.
FIG. 11 is a diagram illustrating a second circuit bonding process according to an embodiment.
FIG. 12 is a diagram illustrating a package finishing process according to an embodiment.
FIG. 13 is a flowchart illustrating a process of manufacturing an integrated package according to an embodiment.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," "pixel-specific," etc.) may be occasionally interchangeably used with a corresponding non-hyphenated version (e.g., "two dimensional," "predetermined," "pixel specific," etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other.

It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. It will be understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, the term "module" refers to any combination of software, firmware and/or hardware configured to provide the functionality described herein in connection with a module. For example, software may be embodied as a software package, code and/or instruction set or instructions, and the term "hardware," as used in any implementation described herein, may include, for example, singly or in any combination, an assembly, hardwired circuitry, programmable circuitry, state machine circuitry, and/or firmware that stores instructions executed by programmable circuitry. The modules may, collectively or individually, be embodied as circuitry that forms part of a larger system, for example, but not limited to, an integrated circuit (IC), system on-a-chip (SoC), an assembly, and so forth.

Many applications, especially applications in Artificial Intelligence (AI) and signal processing, require a vast storage capacity and high throughput computations. To satisfy these needs, highly dense circuits would be packed into highly integrated packages with very short interconnection delays. In addition, for high-speed applications, decoupling capacitors would need to be placed at strategic locations to maintain signal integrity without occupying much space. In the following, systems and methods are described for a technique of fabricating highly integrated semiconductor packages that combines heterogenous digital components, (e.g., applications specific integrated circuits (ASICs), memories, and input/output (IO) or interface circuits) with other passive or mechanical elements to provide fast processing time in a noise-suppressing and well-managed thermal environment.

In one embodiment, an integrated package includes an interposer, a first circuit layer, a second circuit layer, and a thermal layer. The interposer has a top surface and a bottom surface. The first circuit layer is disposed on the top surface by a first bonding and has at least one first circuit. The second circuit layer is disposed on the first circuit layer by a second bonding and has at least one second circuit. The two bondings provide gapless placement for fast accesses and space-saving layout. The thermal layer having an embedded liquid cooling channel is bonded on the second circuit layer to provide thermal management to cool the circuits. A power layer is disposed between the interposer and a signal layer in the first circuit layer and has power vias for an efficient power delivery network. A substrate is attached to the bottom surface via interconnecting bumps and includes at least one stack capacitor for signal decoupling and/or filtering.

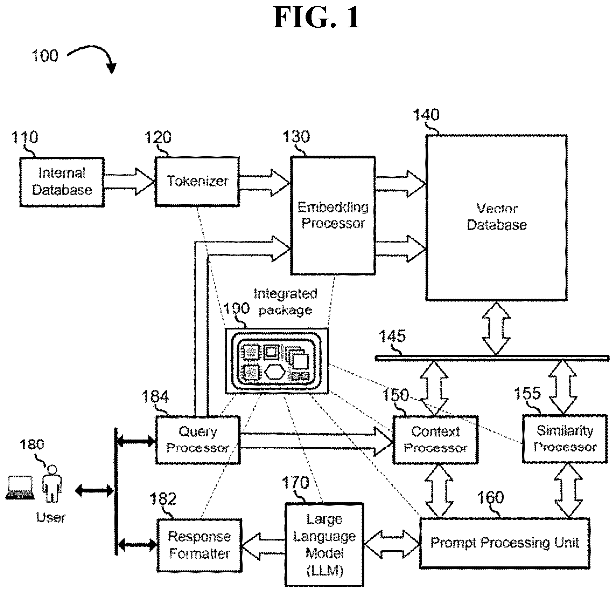

FIG. 1 is a block diagram illustrating a system 100 according to an embodiment. The system 100 includes an internal database 110, a tokenizer 120, an embedding processor 130, a vector database 140, a connectivity link 145, a context processor 150, a similarity processor 155, a prompt processing unit 160, a large language model (LLM) 170, a response formatter 182, a query processor 184, and a user 180. The system 100 may include more or less than the above components. The system 100 illustrates an exemplary architecture of an artificial intelligence (AI) query-and-response application. This query-and-response application receives queries from the user 180 and provide the response using the LLM 170. This type of application may be implemented by hardware or software or a combination of both. The reason why this application is used as an example to illustrate the role of the highly integrated package is that it uses a very large computational resources including large storages for data and high computations. Whether it is implemented by hardware, software, or a combination of both, the basic component of the system is an integrated package 190 that is used in large quantity in the tokenizer 120, the embedding processor 130, the context processor 150, the similarity processor 155, the prompt processing unit 160, the LLM 170, the response formatter 182, and the query processor 184. Some of the components may be parts of other components. For example, the tokenizer 120 and the embedding processor 130 may be parts of the LLM 170.

The internal database 110 is a database that stores data or information that is private to an organization and is not available publicly. The query session may be used by an employee of a company and therefore the data may be private or proprietary to the company. The internal database 110 may not be needed if the query is for public information. The tokenizer 120 processes the data from the internal database 110 and prepares for use in subsequent stages. A typical input is a text or a sentence. The tokenizer 120 breaks the text into smaller units, called tokens, which may be a word or a phrase, or a form that can be processed by other units. Typically, this task may include extracting relevant information from the text and represent this information by meaningful numbers. This may be performed by a special program, or a special circuit which may be implemented in an application-specific integrated circuit (ASIC). Such an ASIC would need to have fast access to memories which store the texts and the tokens. An ASIC with direct access to a storage element in the same package is useful for this purpose.

The embedding processor 130 operates on the output of the tokenizer and the query processor to convert this textual representation into a numeric representation that follows some predefined format. The embedded representation typically has several fields of numbers which may correspond to relevance, relationship, or any characteristics that are useful for processing. These embedded representations typically form vectors. For example, the textual representation "I love New York" may be embedded into a vector having five fields: [0.312, -7.215, 3.126, - 0.015, 2.761]. The embedding process may be implemented in hardware using an integrated package 190 including an ASIC that calculates the vector representation and storage elements that store information retrieved from the internal database 110. The resulting vectors may be stored in the vector database 140 or may be processed with data read from the vector database 140. The vector database 140 store vectors that represent domain knowledge and/ or the query. The output of the vector database 140 may be passed to the context processor 150 and the similarity processor 155 via the connectivity link 145 for further processing. The connectivity link 145 may be a bus, a network connection, or any medium that allows data transfers between the vector database 140 and other devices including the context processor 150 and the similarity processor 155

The context processor 150 provides contextual information to the query or queries. It receives query information from the query processor 184. The contextual information expands the meaning of the query or queries to include information that is relevant to the content of the query or queries and/or user's background and experience. For example, the queries "What is the capital of California?", "What to do in Central California?" and "Where is Yosemite?" may create a context of traveling. This context will obtain vectors that are related to traveling in California including lodging information and attractions. The context processor 150 therefore requires fast computation to perform searches and matching. It also needs a large memory space to store data. The similarity processor 155 performs matching of candidate vectors to the query vector or vectors to locate the vectors that are most relevant to the query. Depending on the format of the query, an appropriate similarity measure may be determined. For example, for vectors with many numerical values, a cosine similarity may be used. This similarity measure requires calculating an inner product and magnitudes of two vectors. When searching for relevant vectors, thousands of such computations may be performed. This number of computations necessitates an ASIC dedicated for similarity computations. Accordingly, the similarity processor 155 may be efficiently implemented by multiple highly integrated packages that include computational elements in forms of ASIC chiplets for fast and parallel computations. In addition, it should also have a large memory capacity to provide fast access to the vectors. Both the context processor 150 and the similarity processor 155 would also need efficient input/output (IO) circuits to perform fast data transfers to and from the vector database 140 and the prompt processing unit 160.

The prompt processing unit 160 receives results from the context processor 150 and the similarity processor 155 to further provide guidance to steer the LLM 170 to the appropriate direction. Due to the amount of vast information processed by the LLM 170, there is a good chance that the LLM 170 strays into off topic areas, referred to as hallucinations. The prompt processing unit 160 narrows down the search space, based on the contextual information from the context processor 150 and the candidate vectors from the similarity processor 155 and additional information such as user's profile, background, or experience. The prompt processing unit 160 may import domain-specific knowledge data to generate proper directions for the query. It may interact with the context processor 150 and the similarity processor 155 to generate prompts to the LLM 170. Accordingly, it would need a highly integrated package with ASIC chiplets and localized memory and IO or interface circuits.

The LLM 170 obtains results from the prompt processing unit 160 including those of the context processor 150 and the similarity processor 155 to generate a response to the query. It also receives query information from the query processor 184. The LLM 170 includes a transformer model having computations that are partly offloaded to the tokenizer 120, the embedding processor 130, the context processor 150, and the similarity processor 155. It includes an encoder and decoder structure to create and process a contextualized representation of the query, a training model to learn the meaning of the query and process the query, an inference engine to reason for a proper response, and a fine-tuning structure to refine the responses based on the results of the context processor 150 and the similarity processor 155. Typically, the LLM 170 involves a massive amount of memory space and computations. Many of the computations may be performed in parallel where there is little or no dependency. Accordingly, the LLM 170 would need multiple highly integrated packages having several computational and memory elements with specific algorithms. This is most efficient by multiple ASICs with direct accesses to local memory devices.

The response formatter 182 receives one or more responses from the LLM 170. These responses correspond to the user query or queries. The response formatter 182 formats these responses in proper format and presentation style which may include graphics and animation. The result is then delivered to the user 180. Due to the amount of computations and IO interactions, the response formatter 182 is best implemented by a highly integrated package like the integrated package 190 which includes multiple ASIC, memory, and IO circuits.

The query processor 184 processes the query from the user 180. This process may include tokenization as done by the tokenizer 120 and other formatting operations to convert the user's query into a form that can be further processed. The results of the query processor 184 are delivered to the embedding processor 130, the context processor 150, and the LLM 170. Though the computations in the query processor 184 may or may not be extensive, it often needs fast processing time and specialized procedures. Accordingly, the query processor 184 is best implemented by a highly integrated packages having multiple ASIC, memory, and IO circuits.

The user 180 may be any user of the system and may include an individual, a team of people, or a computerized process. The user 180 may have a query that is in the public domain and expect the results to be obtained from the public domain. The user 180 may also be a user who has a private query that is particularized for the platform the user 180 is using. For example, the user 180 may be an individual who is interested in knowing the products offered by a company XYZ. As another example, the user 180 may belong to an organization such as a union or an association who want to query a particular subject that is relevant only to that organization. Under this private setting, the internal database 110 is relevant.

The system 100 is an example that illustrates the role of highly integrated packages in high computing (HC) platforms. The use of a query application in AI shows that many HC platforms require several ASIC chiplets operating in conjunction with memory or IO circuits. In many cases, the environment of the applications adds additional requirements including low power consumption, reliable signal integrity, fault-tolerance, and reliable operations in extreme conditions including heat and tight space. Examples of other applications that would benefit from a highly integrated package design include mobile communication (e.g., smart phones, base stations, user equipment), cameras, vehicles, entertainment (e.g., games, multimedia, music, movies), technical designs (e.g., animation, graphics), medical (e.g., visualization, medical imaging), robotics, drones, automatic test equipment, audio processing, speech synthesizer, video and image analysis, vision, automatic face recognition. Many of these requirements present challenges because they may lead to contradictory requirements. Accordingly, embodiments described in this disclosure aim at achieving these objectives with a systematic approach for structural and operational coherence. Structural coherence refers to consistency in placement of components to achieve various objectives. For example, when more components are packed together such as stacked memory circuits, a cooling channel would be placed near these components. As another example, when high-frequency operations are performed, stacked capacitors would be placed nearby to maintain signal integrity and reduce noise. In addition to structural and operational coherence, embodiments offer an architecture that provides flexibility and scalability so that the integrated package may be modified to accommodate different environments or applications.

In the following, description will focus on several embodiments of the integrated package 190. These embodiments may be combined to provide highly integrated and versatile packages.

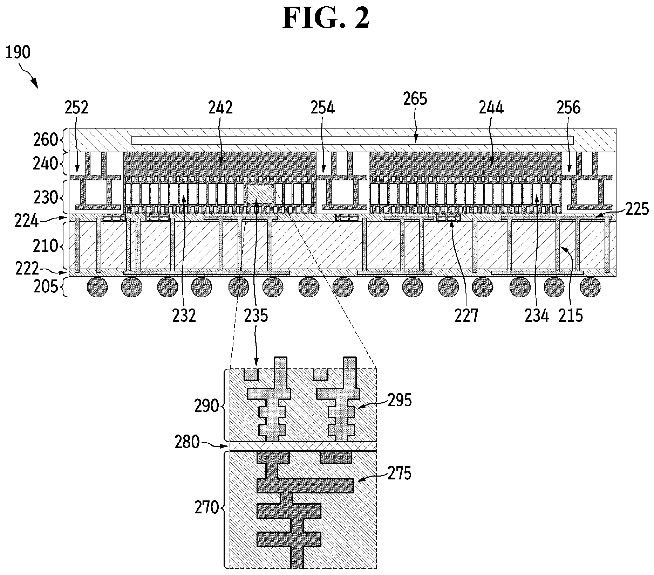

FIG. 2 is a diagram illustrating the integrated package 190 with BSPDN according to an embodiment. The integrated package 190 includes an interposer 210, interlayer dielectrics (ILD) 222 and 224, a first circuit layer 230, a second circuit layer 240, separator dielectrics 252, 254, and 256, a thermal layer 260, and interconnecting elements 205. The integrated package 190 with BSPDN may include more or less than the above components. The integrated package 190 may implement the similarity processor 155 in FIG. 1 to perform calculations for similarity matching between database vectors from the vector database 140 and a query vector from a query processor that processes a query from the user 180 (FIG. 1)

BSPDN(Back Side Power Delivery Network) places power delivery interconnects on the backside of the wafer or the semiconductor chips and therefore freeing up more space for signal interconnects and device circuits on the frontside. Using BSPDN in an integrated package would help increase logic density and improve power and performance.

The interposer 210 is a thin substrate made of a semiconductor material such as silicon (Si). It provides interfaces among components having different characteristics or form factors. It also helps routing signals through vias. It includes several through silicon vias (TSVs) 215. The TSVs 215 provide electrical connections passing though the interposer 210. The ILDs 222 and 224 are attached to the bottom and top sides of the interposer 210. The ILDs 222 and 224 define the bottom and top surfaces, respectively, for the interposer 210. In other words, the top surface of the ILD 224 defines the top surface of the interposer 210 and the bottom surface of the ILD 222 defines the bottom surface of the interposer 210. That is, depending on the context, the ILDs 222 and 224 may be considered as an integral part of the interposer. The ILDs 222 and 224 provide electrical insulation, signal routing or interconnect 225, and housing for integrated stack capacitors (ISCs) 227. The ISCs 227 may be used as decoupling capacitors for filtering high-frequency noises to provide signal integrity. In one embodiment, they may be made by a Si substrate with thousands of concave vias in a cell.

The first circuit layer 230 is bonded onto or disposed on the top surface of the interposer 210 by first bonding (interface), exemplarily a first die-to-wafer hybrid bonding (D2WHB). It has at least one first circuit. Fig. 2 shows two first circuits 232 and 234. The first circuit 232 or 234 may be an application specific integrated circuit (ASIC), a memory circuit, or an input/output (IO) circuit. When used as a similarity processor 155 in FIG. 1, the first circuit 232 or 234 may be an ASIC circuit that performs similarity matching between the database vectors in a vector database 140 (FIG. 1) and the query vector from the query. The second circuit layer 240 is bonded onto or disposed on the first circuit layer 230 by a second bonding (interface), exemplarily by a second D2WHB. It has at least one second circuit. Fig. 2 shows two second circuits 242 and 244. The second circuit 242 or 244 may be an application specific integrated circuit (ASIC), a memory circuit, or an input/output (IO) circuit. In one embodiment, the first circuits 232 and 234 are of types different from those of the second circuits 232 and 234. For example, the first circuit 232 may be an ASIC circuit that performs similarity matching between the database vectors and a query vector, the first circuit 234 may be an IO or interface circuit that performs communication or data or message transfers, the second circuit 242 may be a memory circuit that stores results of the similarity matching, and the second circuit 244 may be an ASIC circuit that performs sorting of the results of the similarity matching performed by the first circuit 232.

The first circuit layer 230 includes a region 235 that may contain a BSPDN. In one embodiment, the region 235 is provided in both the first circuits 232 and 234. In other embodiments, one of the first circuits 232 and 234 does not have the BSPDN. The region 235 has a backside power layer 270, a transistor layer 280, and a signal layer 290. The backside power layer 270 is disposed between the interposer 210 and the transistor layer 280 or the signal layer 290. The backside power layer 270 includes power vias 275 to implement a BSPDN. The power vias connect power voltage sources to various terminals of the circuits in the first and second circuit layers 230 and 240. The signal layer 290 is part of the first circuit layer 230 and contains signal vias 295 that connect signals of the corresponding circuit.

The separator dielectrics 252, 254, and 256 separate the first circuit layer 230 and second circuit layer 240 into two regions that are filled or occupied by the first circuits 232 and 234 and the second circuits 242 and 244, respectively. They contain interconnecting elements or vias that connect elements in the various layers.

The thermal layer 260 is bonded on the top surface of the second circuit layer 240 to provide thermal relief for the underneath circuits. In one embodiment, the thermal layer 260 is made of glass or silicon. It has an embedded liquid cooling channel 265. The liquid cooling channel 265 is embedded within the thermal layer 260 and is constructed by a hollow channel. Cooling liquid is supplied through the channel to cool the surrounding areas

The interconnecting elements or bumps 205 are attached to the bottom surface of the interposer 210. They may be controlled collapse chip connection (C4) or micro bumps. They provide interconnection to a component that may be attached to the integrated package 190.

The formation and placement of the ISCs 227, the BSPDN in the region 235, the embedded liquid cooling channel 265, and the two D2WHBs aim at achieving separate objectives but are designed to provide a structural coherence for high performance computing elements. The ISCs 227 provide decoupling and enhance signal integrity. The BSPDN provides more space on the front end for the active circuits. The embedded liquid cooling channel 265 provides thermal management to cool the circuits. The two D2WHBs provide gapless integrated circuits for fast accesses and space-saving placement. Additional configurations described in the following provide flexibility in placement of circuits and package elements.

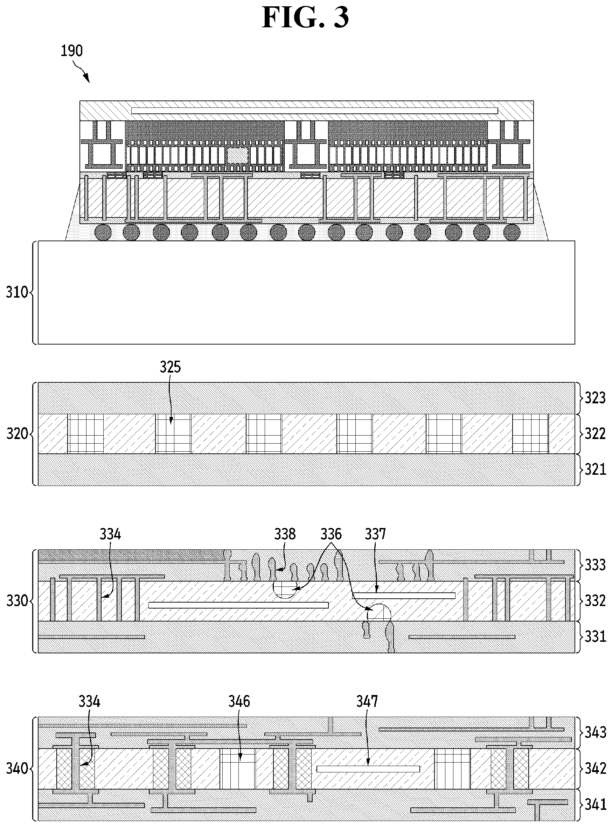

FIG. 3 is a diagram illustrating the integrated package 190 having a substrate according to an embodiment. The integrated package 190 in FIG. 3 includes the integrated package 190 shown in FIG. 2 and a substrate 310. For brevity, description on the integrated package 190 shown in FIG. 2 will not be repeated and the focus will be on the substrate 310. The substrate 310 is attached to the bottom surface of the interposer 210 via the interconnecting elements 205. There are at least three embodiments of the substrate 310: an organic substrate 320, a glass substrate 330, and a Si substrate 340.

The organic substrate 320 includes three layers 321, 322, and 323. The three layers are made of an organic material such as polymers or small organic molecules including pentacene, anthracene, and rubrene. The three layers 321, 322, and 323 are essentially the same, except that the layer 322, and made of the same material. The organic material provides mechanical flexibility, lightweight, and low cost. The layer 322 is the substrate core and includes at least one embedded capacitor 325. The capacitor 325 may be an ISC and is any suitable capacitor to provide filtering and/or decoupling functionality for the overall integrated package.

The glass substrate 330 includes three layers 331, 332, and 333. The three layers are made of glass. The layer 331 may include vias or interconnecting elements to connect to elements in the layer 332. The layer 332 may include through glass vias (TGVs) 334, capacitor 336, and liquid cooling channel 337. The TGVs 334 provide interconnections for various components in the package. The capacitor 336 may be an ISC embedded in the grooves in the glass to provide filtering and/or decoupling functionality. The liquid cooling channel 337 provides thermal cooling function for the substrate. The layer 332 may include more or less than the above components. The layer 333 may be a build-up layer or a redistribution layer (RDL) to provide IO pads or other interconnection locations in the package. It includes various vias 338 for interconnecting function.

The Si substrate 340 includes three layers 341, 342, and 343. The three layers are made of silicon (Si). The layer 341 includes vias and interconnecting patterns. The layer 342 includes at least one of a via 344, a capacitor 346, and a liquid cooling channel 347. The layer 342 may include more or less than the above components. The via 344 may be a through silicon via (TSV), a coaxial via (COV), or copper (Cu) via-in-via. The capacitor 346 may be an ISC and provides filtering or decoupling functionality. The liquid cooling channel 347 provides cooling for the substrate. The layer 343 may be a build-up layer or RDL.

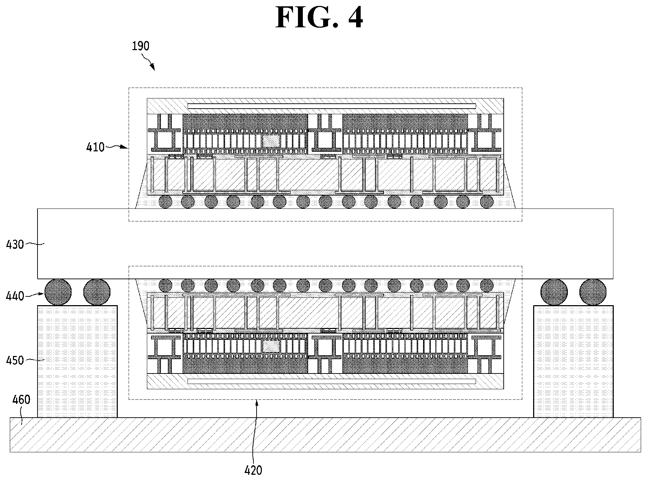

FIG. 4 is a diagram illustrating the integrated package 190 with a dual configuration according to an embodiment. The integrated package 190 includes a package 410, a package 420, a substrate 430, interconnecting bumps 440, and interconnecting elements 450. The integrated package 190 in FIG. 4 may include more or less than the above components.

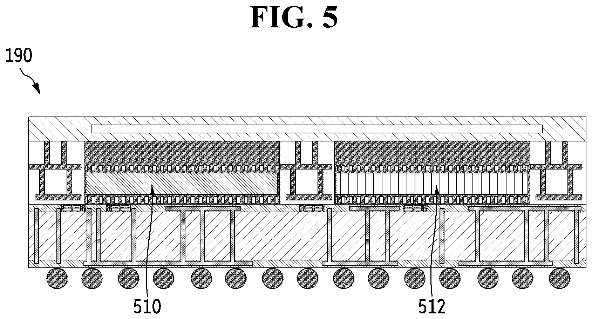

The package 410 is the same as the package 190 shown in FIG. 2. Therefore, its description is omitted. It is attached to the substrate 430 by the interconnecting bumps. The package 420 is the same as the package 410 except that it is turned upside down or flipped horizontally so that the interconnecting bumps face upward to be attached to the substrate 430. The package 410 and the package 420 are not necessarily identical. Since each of them has variants, they can be any of the variants, including those in FIG. 5, 6, 7, and 8. The substrate 430 is similar to the substrate 310 in FIG. 3 and may have any one of the configurations of the substrates 320, 330, and 340 in FIG. 3. The interconnecting bumps 440 are used to attach the substrate 430 to the interconnecting elements 450. The interconnecting elements 450 provides attachment to a printed circuit board (PCB) or a platform 460.

FIG. 5 is a diagram illustrating the integrated package 190 with an alternative BSPDN arrangement according to an embodiment. The integrated package 190 in FIG. 5 is similar to the integrated package 190 in FIG. 2 except that the BSPDN is provided in one of the two first circuits 232 and 234. Therefore, for brevity, the description and reference signs for most components in the package 190 are omitted except that the integrated package 190 in FIG. 5 has two first circuits 510 and 512. The first circuit 510 does not have a BSPDN and the first circuit 512 has a BSPDN as the first circuits 232 and 234 in FIG. 2.

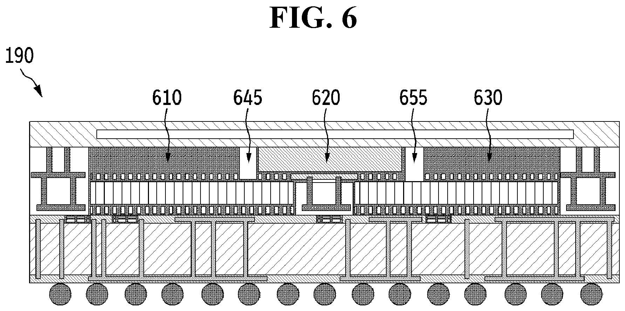

FIG. 6 is a diagram illustrating the integrated package 190 with an alternative second circuit arrangement according to an embodiment. The integrated package 190 in FIG. 6 is similar to the integrated package 190 in FIG. 2 except that the second circuit layer 240 includes a variety of circuits including memory circuits, IO or interface circuits, and even ASIC circuits. For brevity, the description and reference labels of similar components are omitted. The number of the second circuits may also be varied. The second circuit layer 240 includes a second circuit 610, a second circuit 620, and a second circuit 630. They are separated by dielectrics 645 and 655. The second circuits 610, 620, and 630 may be any combination of circuits. For example, the second circuit 610 may be a memory circuit, the second circuit 620 may be an IO or interface circuit or an ASIC circuit, and the second circuit 630 may be a memory circuit. The die size in the second layer 240 may be the same or different from the die size in the first layer 230

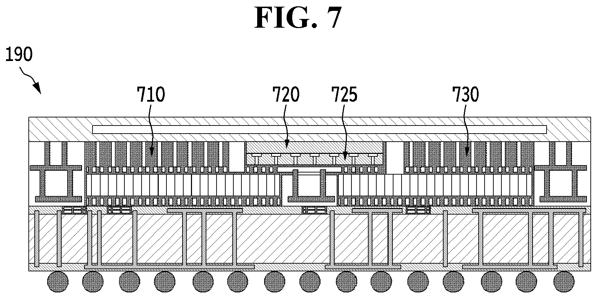

FIG. 7 is a diagram illustrating the integrated package 190 with a customized memory stack according to an embodiment. The integrated package 190 in FIG. 7 is similar to the integrated package 190 in FIG. 2 except that the second circuit layer 240 includes a variety of circuits including 3-D circuit stacks such as memory (e.g., SRAM, DRAM) stacks. For brevity, the description of similar components is omitted. The second circuit layer 240 includes a second circuit 710, a second circuit 720, and a second circuit 730. These circuits may be different circuits. For example, the second circuit 710 may be a memory (e.g., DRAM) stack, the second circuit 720 may be a customized memory stack having interconnecting elements 725 to provide support for circuit stacks, and the second circuit 730 may be another memory stack.

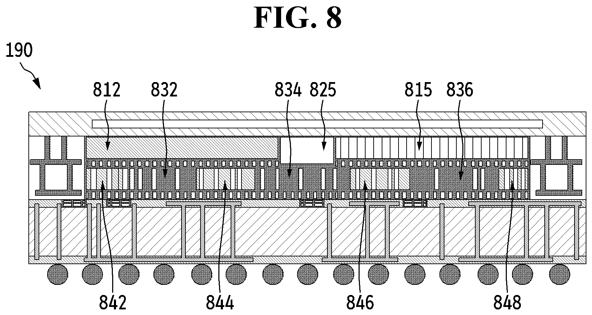

FIG. 8 is a diagram illustrating the integrated package 190 with a mix of alternative arrangements according to an embodiment. The integrated package 190 in FIG. 8 is similar to the integrated package 190 in FIG. 2 except that it has a mix of alternative arrangements of circuits. For example, the first circuits and the second circuits are swapped so that the ASIC circuits or circuits having higher power consumption are located closer to the thermal layer 260 to have better heat dissipation. For brevity, the description and reference labels of similar elements are omitted. The integrated package 190 in FIG. 6 includes second circuits 812 and 815 located in the second circuit layer 240 and first circuits 832, 834, and 836 are located in the first circuit layer 230. The second circuit 812 may be an ASIC circuit without BSPDN. The second circuit 815 may be an ASIC circuit with BSPDN. They are separated by a dielectric 825. The first circuit 832 may be memory circuit such as an SRAM, DRAM, cache, or HBM. The first circuit 834 may be an IO or an ASIC circuit. The first circuit 836 may be a memory circuit. The first circuits 832, 834, and 836 are separated by dielectrics 842, 844, 846, and 848.

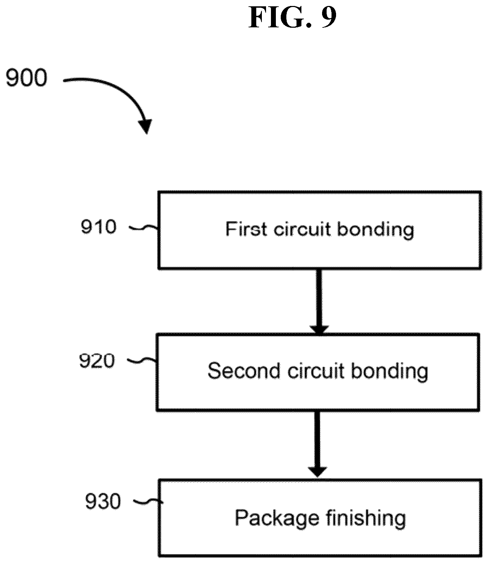

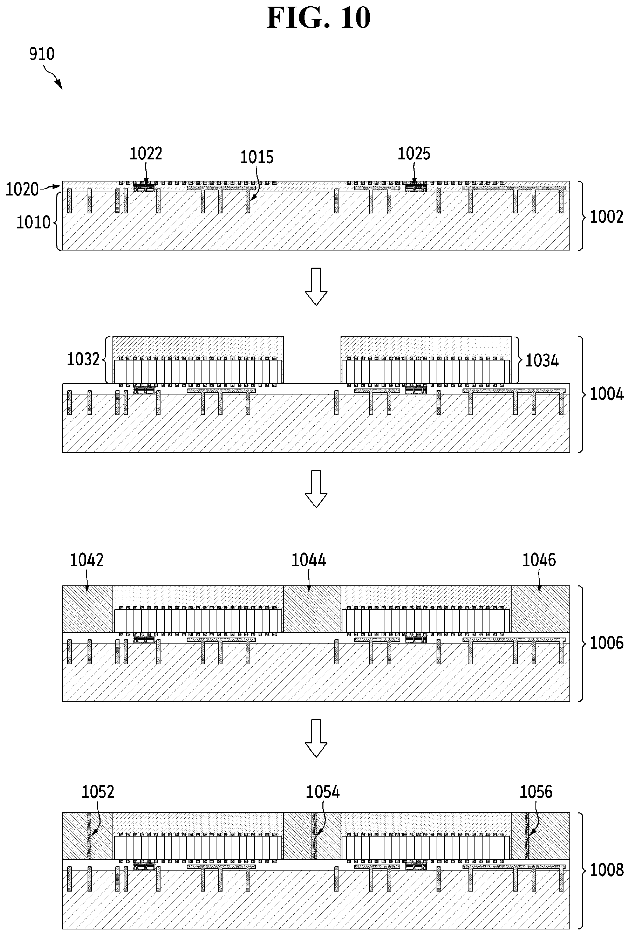

FIG. 9 is a diagram illustrating an overview of a manufacturing process 900 flow according to an embodiment. For ease of presentation, the process 900 includes three processes: a first circuit bonding 910, a second circuit bonding 920, and a package finishing 930. The processes first circuit bonding 910, second circuit bonding 920, and package finishing 930 will be described in FIG. 10, FIG. 11, and FIG. 12, respectively. Each process generates multiple packages at multiple stages. Each package modifies, removes, or adds a component in the previous package. For clarity, only a modified or added component are labeled. Non-labeled components retain the same reference numerals as in the previous stage. The first circuit bonding process 910, the second circuit bonding process 920, and the package finishing process 930 describe the formation of the integrated package with focus on the physical aspects of the layers.

FIG. 10 is a diagram illustrating the first circuit bonding process 910 according to an embodiment. The process 910 includes stages that produce packages 1002, 1004, 1006, and 1008.

The package 1002 includes an interposer 1010 and a dielectric layer 1020. The interposer 1010 may be made of silicon. It has several through silicon vias (TSVs) 1015 to interconnect elements in the package. The dielectric layer 1020 has integrated stack capacitors (ISC) 1022 and 1025 to provide decoupling to circuits in the package.

The process 910 disposes two ASIC chiplets or circuits 1032 and 1034 on the dielectric 1020 to form the package 1004. The process 910 uses a die-to-wafer hybrid bonding (D2WHB) to bond the ASIC circuits 1032 and 1034 on the dielectric layer 1020. This bonding improves yield. The two ASIC circuits 1032 and 1034 have BSPDN in their signal layer. They are positioned with a gap between them and gaps from the edge.

The process 910 then deposits or places Si oxide or other dielectric to form dielectrics 1042, 1044, and 1046 to fill the gaps from the edges and between the ASIC circuits 1032 and 1034 (the inter-die gap). This stage forms the package 1006.

Next, the process 910 forms vias 1052, 1054, and 1056 in the dielectrics 1042, 1044, and 1046, respectively, to form the package 1008. The process 910 then goes to the second circuit bonding process 920.

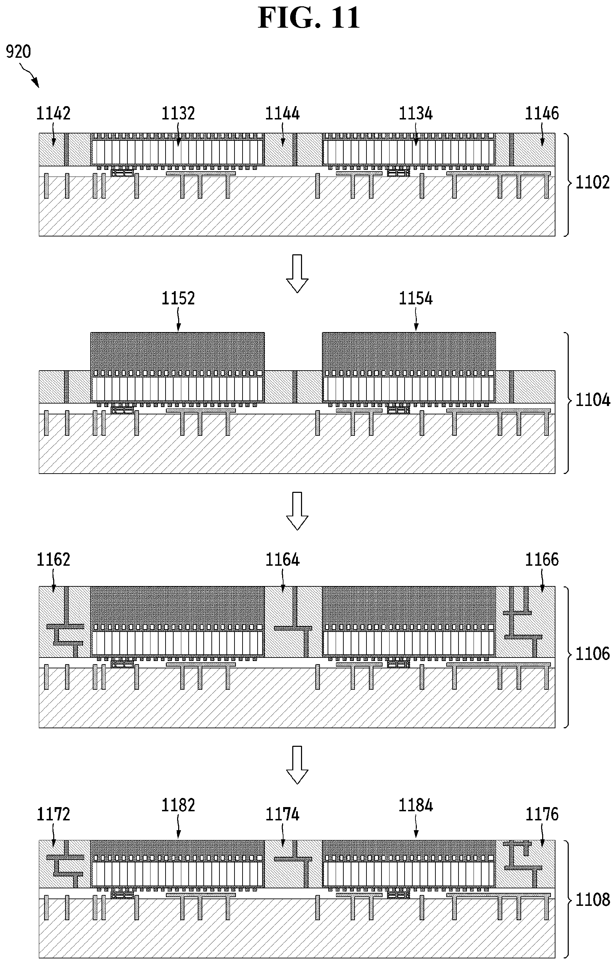

FIG. 11 is a diagram illustrating the second circuit bonding process 920 according to an embodiment. The process 920 includes stages that start with the package 1008 in FIG. 10 to produce packages 1102, 1104, 1106, and 1108.

The process 920 thins down the ASIC circuits 1032 and 1034 and the corresponding dielectrics 1042, 1044, and 1046 to form the package 1102. The thinned down ASIC circuits 1032 and 1034 become the ASIC chiplets 1132 and 1134, respectively. The thinned down dielectrics 1042, 1044, and 1046 become 1142, 1144, and 1146, respectively.

Next, the process 920 places a memory circuit 1152 and an IO or interface circuit or ASIC circuit 1154 on the ASIC chiplets 1132 and 1134, respectively to form the package 1104. There are gaps at the edges and between the memory circuit 1152 and the IO or interface circuit or ASIC chiplet 1154.

Then, the process 920 places dielectrics 1162 and 1166 at the edges and dielectric 1164 between the memory circuit 1152 and the IO or interface circuit or ASIC chiplet 1154 to form the package 1106. The process 920 introduces vias to form interconnecting paths in the dielectrics 1162, 1164, and 1166 if necessary.

Next, the process 920 thins down the memory circuit 1152 and the IO or interface circuit or ASIC chiplet 1154 and the corresponding dielectrics 1162, 1164, and 1166 to form the package 1108. The thinned down dielectrics 1162, 1164, and 1166 become 1172, 1174, and 1176, respectively. The thinned down circuits 1152 and 1154 become a thinned down memory circuit 1182 and a thinned down IO or interface circuit or ASIC circuit 1184, respectively. The process 920 then goes to the package finishing process 930.

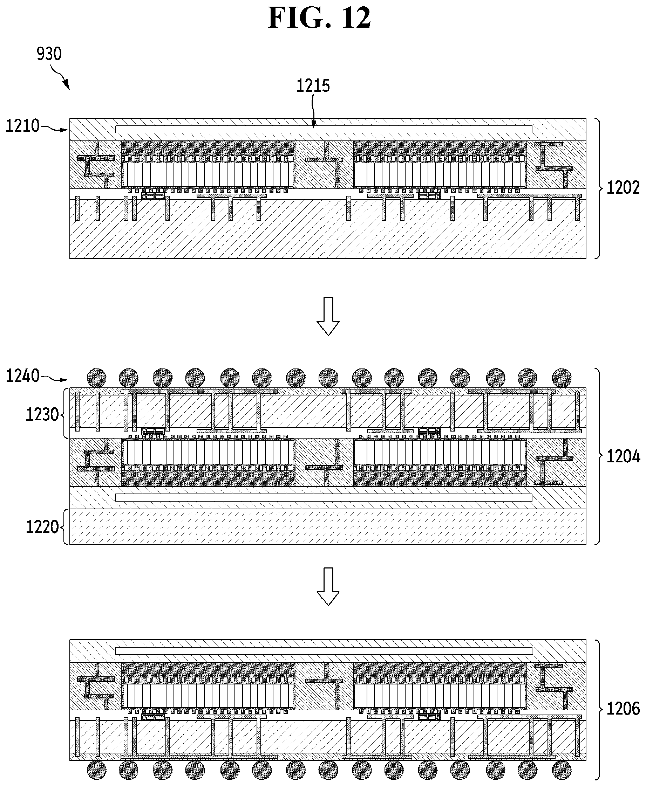

FIG. 12 is a diagram illustrating the package finishing process 930 according to an embodiment. The process 930 includes stages that start with the package 1108 in FIG. 11 to produce packages 1202, 1204, and 1206.

The process 930 bonds a diamond or glass or Si layer 1210 on top of the package 1108 to form the package 1202. The diamond or glass or Si layer 1210 provides thermal management layer for the circuits below. It includes an embedded liquid cooling channel 1215.

Next, the process 930 bonds a carrier 1220 on the diamond or glass or Si layer 1210, performs a via reveal on the interposer to become an interposer 1230, and attaches interconnecting bumps 1240 to the interposer 1230 to form the package 1204. The package 1204 is flipped horizontally to facilitate the process.

Then, the process 930 removes the carrier 1220 from the package 1204 to form the package 1206. The removal is done by a debonding process. The package 1206 is the end of the package finishing process.

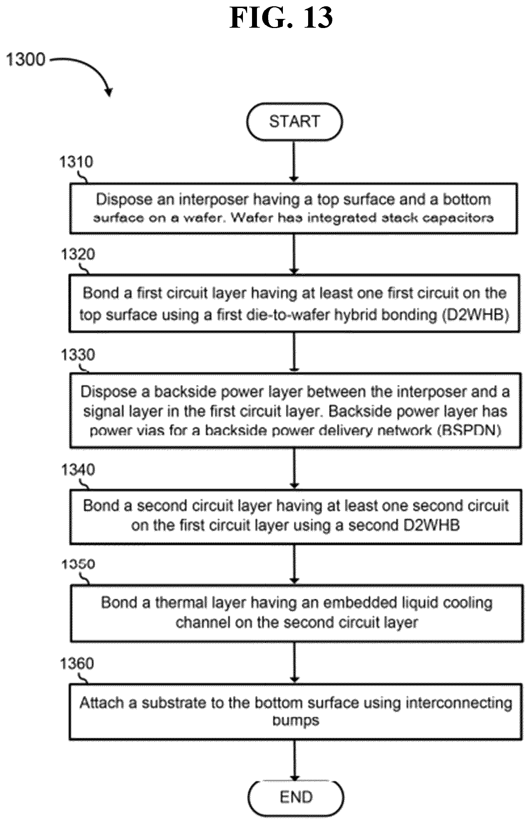

FIG. 13 is a flowchart illustrating a process 1300 of manufacturing an integrated package according to an embodiment. The process 1300 describes the steps that form the integrated package with focus on the result at each step.

Upon START, the process 1300 disposes an interposer having a top surface and a bottom surface on a wafer (Block 1310). The wafer has integrated stack capacitors. Then, the process 1300 bonds a first circuit layer having at least one first circuit on the top surface using a first die-to-wafer hybrid bonding (D2WHB) (Block 1320). The at least one first circuit may be an ASIC circuit, a memory circuit, or an IO circuit. Next, the process 1300 disposes a backside power layer between the interposer and a signal layer in the first circuit layer (Block 1330). The backside power layer has power vias for a backside power delivery network (BSPDN).

Then, the process 1300 bonds a second circuit layer having at least one second circuit on the first circuit layer using a second D2WHB (Block 1340). The at least one second circuit may be an ASIC circuit, a memory circuit, or an IO or interface circuit. Next, the process 1300 bonds a thermal layer having an embedded liquid cooling channel on the second circuit layer (Block 1350). Then, the process 1300 attaches a substrate to the bottom surface using interconnecting bumps (Block 1360). The substrate may be made of an organic material, silicon, or glass. The silicon or glass substrate may include at least one liquid cooling channel.

The integrated package described with various embodiments above provides several advantages in high-performance computing systems. The memory chips (including cache, SRAM, DRAM, and HBM) are directly integrated to the signal layers of ASIC circuits with BSPDN. This provides much faster memory accesses with lower power consumption, wider bandwidth, and larger capacity. In addition, ASIC circuits with BSPDN separate PDN from the signal network. This improves the PDN performance. Furthermore, better PDN performance is achieved by embedding ISCs in the Si interposer and substrates. The use of Si interposer with embedded ISCs to connect ASIC circuits enables heterogeneous package. ASIC chiplets with different Si nodes can be integrated into one package. Moreover, the 3D integrated circuit is gapless, achieved by D2WHB technique. This provides denser interconnects and better thermal management. Diamond or glass or Si with embedded liquid cooling channels are directly bonded to the top dies for better thermal solutions. Si and glass substrates may be used for the assembly to generate large packages with better performance thanks to the stiffness of Si and glass, as well as their superior electrical properties. Additionally, using Si or glass substrates can provide better thermal performance because liquid cooling channels can be embedded into the Si or glass substrates. All of these features are achieved through a collection of processes that provide a structural and functional coherence to achieve various objectives in the same integrated package.

Embodiments of the subject matter and the operations described in this specification may be implemented in digital electronic circuitry, or in computer software, firmware, or hardware, including the structures disclosed in this specification and their structural equivalents, or in combinations of one or more of them. Embodiments of the subject matter described in this specification may be implemented as one or more computer programs, i.e., one or more modules of computer-program instructions, encoded on computer-storage medium for execution by, or to control the operation of data-processing apparatus. Alternatively or additionally, the program instructions can be encoded on an artificially-generated propagated signal, e.g., a machine-generated electrical, optical, or electromagnetic signal, which is generated to encode information for transmission to a suitable receiver apparatus for execution by a data processing apparatus. A computer-storage medium can be, or be included in, a computer-readable storage device, a computer-readable storage substrate, a random or serial-access memory array or device, or a combination thereof. Moreover, while a computer-storage medium is not a propagated signal, a computer-storage medium may be a source or destination of computer-program instructions encoded in an artificially-generated propagated signal. The computer-storage medium can also be, or be included in, one or more separate physical components or media (e.g., multiple CDs, disks, or other storage devices). Additionally, the operations described in this specification may be implemented as operations performed by a data-processing apparatus on data stored on one or more computer-readable storage devices or received from other sources.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable sub-combination. Moreover, although features may be described above as acting in certain combinations and even initially claimed as such, one or more features from a claimed combination may in some cases be excised from the combination, and the claimed combination may be directed to a sub-combination or variation of a sub-combination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

As will be recognized by those skilled in the art, the innovative concepts described herein may be modified and varied over a wide range of applications. Accordingly, the scope of claimed subject matter should not be limited to any of the specific exemplary teachings discussed above, but is instead defined by the following claims.

## Claims

1. A device comprising:
an interposer (210) having a top surface and a bottom surface;
a first circuit layer (230) disposed on the top surface by a first bonding, the first circuit layer (230) having at least one first circuit (232, 234; 832, 834, 836);
a second circuit layer (240) disposed on the first circuit layer (230) by a second bonding, the second circuit layer (240) having at least one second circuit (242, 244; 610, 620, 630; 710, 720, 730; 812, 815); and
a thermal layer (260) having an embedded liquid cooling channel (265) and bonded on the second circuit layer (240).

2. The device of claim 1 further comprising:
a backside power layer (270) disposed between the interposer (210) and a signal layer (290) in the first circuit layer (230) and having power vias (275) for a power network.

3. The device of claim 1 or 2, wherein the thermal layer (260) is made of one of glass or silicon.

4. The device of any one of claims 1 to 3 further comprising:
a substrate (310, 320, 330, 340; 430) attached to the bottom surface via interconnecting bumps (205).

5. The device of claim 4, wherein the substrate (310, 320, 330, 340; 430) includes at least one stack capacitor (336, 346).

6. The device of claim 4 or 5, wherein the substrate (310, 330, 340; 430) is made of one of glass or silicon and includes at least one liquid cooling channel (337, 347).

7. The device of any one of claims 4 to 6, wherein the substrate is made of one of glass or silicon and includes at least one of a build-up layer or a redistribution layer (333, 343).

8. The device of any one of claims 4 to 7, wherein the substrate (310, 330, 340; 430) is made of one of glass or silicon and includes at least one of silicon via, coaxial via, or copper via (334, 344).

9. The device of any one of claims 1 to 8, wherein the at least one first circuit (232, 234; 832, 834, 836) is one of an application specific integrated circuit, ASIC, a memory circuit, or an interface circuit.

10. The device of any one of claims 1 to 9, wherein the at least one second circuit (242, 244; 610, 620, 630; 710, 720, 730; 812, 815) is one of an applications specific integrated circuit, ASIC, a memory circuit, or an interface circuit.

11. A method for integrated packaging, the method comprising:
disposing (1310) an interposer having a top surface and a bottom surface on a wafer;
bonding (1320) a first circuit layer having at least one first circuit on the top surface using a first bonding; and
bonding (1340) a second circuit layer having at least one second circuit on the first circuit layer using a second bonding; and
bonding (1350) a thermal layer having an embedded liquid cooling channel on the second circuit layer.

12. The method of claim 11, further comprising:
disposing (1330) a backside power layer between the interposer and a signal layer in the first circuit layer, the backside power layer having power vias for a power network.

13. The method of claim 11 or 12, wherein the thermal layer is made of one of glass or silicon.

14. The method of any one of claims 11 to 13, further comprising:
attaching (1360) a substrate to the bottom surface using interconnecting bumps.

15. The method of claim 14, wherein the substrate includes at least one stack capacitor.
